# EUROPÄISCHE PATENTSCHRIFT

(11) **EP 2 254 242 B1**
(45) Veröffentlichungstag und Bekanntmachung des Hinweises auf die Patenterteilung: **03.10.2012**
(21) Anmeldenummer: 10003889.2
(22) Anmeldetag: 13.04.2010
(51) Int. Cl.: H03G 3/30, H04N 5/52

(54) **Breitbandverstärker**
Broadband amplifier
Amplificateur à large bande

(30) Priorität: 20.05.2009 DE 102009022087
(43) Veröffentlichungstag der Anmeldung: 24.11.2010
(73) Patentinhaber: ASC-TEC AG Antennen-Satelliten-Communication-Technik, 78351 Bodman (DE)
(72) Erfinder: Boll, Christian, 78351 Bodman (DE); Manz, Werner, 88662 Überlingen (DE)
(74) Vertreter: Weiss, Peter

(56) Entgegenhaltungen:
- WO-A1-2005/009034
- WO-A1-2006/105355
- US-A1- 2005 179 820

## Beschreibung

### Technologischer Hintergrund

Die Erfindung betrifft einen Breitbandverstärker nach dem Oberbegriff des Anspruchs 1.

### Stand der Technik

In diesem Zusammenhang wird auf die US 2006/217092 A1 verwiesen. Dort ist ein Breitbandverstärker beschrieben, welcher über einen DOCSIS-Modem fernsteuerbar ist.

Breitbandverstärker werden in Hausverteileranlagen für Fernsehsignale eingesetzt, um ein an einem Hausübergabepunkt über ein Breitbandkabel übertragenes Signal mit einer Vielzahl von darin enthaltenen Fernsehkanälen oder anderen Informationen auf verschiedene Antennensteckdosen aufzuteilen, sodass an diesen Antennensteckdosen Fernsehsignale für Benutzer oder Teilnehmer bereitgestellt werden. Eine weitere Einsatzmöglichkeit von Breitbandverstärkern ist eine Reichweitenvergrößerung, wobei ein über einen Eingang empfangenes Signal eventuell gefiltert, jedenfalls aber verstärkt, und an einem Ausgang wieder bereitgestellt wird.

Bei allen diesen Anwendungen ist eine Einstellung des Verstärkers, insbesondere eine Einstellung der Verstärkung des Verstärkers notwendig, um den Verstärker an verschiedene Gegebenheiten anzupassen. Weiterhin kann es wünschenswert sein, Signale in Verstärkern auf einzelne oder verschiedene Ausgänge zu schalten oder Verstärker, welche diesen Ausgängen zugeordnet sind, einzustellen oder zu schalten.

Herkömmliche Breitbandverstärker müssen vor Ort eingestellt werden. Dies ist aufwendig und kostenintensiv, da ein Mitarbeiter den Breitbandverstärker aufsuchen muss.

Die US 2005/179820 A1 beschreibt ein System mit einem Fernsehtuner, welcher einen Breitbandverstärker umfasst. Ausserdem wird auf die WO 2004/047411 hingewiesen, welche ebenfalls einen Breitbandverstärker beschreibt, wobei allerdings ein Modem zum Einsatz kommt.

### Offenbarung der Erfindung

Aufgabe der Erfindung ist es, einen Breitbandverstärker bereitzustellen, mit dem Nachteile des bisherigen Standes der Technik überwunden oder zumindest gelindert werden können. Insbesondere ist es Aufgabe der Erfindung, einen Breitbandverstärker anzugeben, die eine möglichst kostengünstige und einfache Steuerung eines Verstärkers, der in einem Breitbandverstärker enthalten ist, zu ermöglichen.

Die Aufgabe wird mit einem Breitbandverstärker nach Anspruch 1 gelöst.

Die Erfindung sieht eine mit dem Eingang des Breitbandverstärkers verbundene Kontrolleinrichtung vor, die geeignet ist, in Abhängigkeit von einem über den Eingang empfangenen Signal einen Verstärker des Breitbandverstärkers zu steuern. Dabei ist der Begriff "zu steuern" vorzugsweise so auszulegen, dass er auch ein Regeln des Verstärkers umfasst. Die Kontrolleinrichtung weist ein DOCSIS-Modem auf, um über den Eingang empfangene Signale zu verarbeiten. Es sollte angemerkt werden, dass die Buchstaben DOCSIS für "Data Over Cable Service Interface Specification" stehen. Ein Ansteuern des Verstärkers geschieht beispielsweise dadurch, dass ein digital verstellbarer Pegelsteller durch die Kontrolleinrichtung eingestellt wird, welcher vor dem Verstärker angeordnet ist, ebenso kann auch ein im Signalweg hinter dem Verstärker angeordneter Pegelsteller angesteuert werden. Dies ist durch den Begriff "den Verstärker steuern" umfasst. Umfasst sind ebenso Verstärker im Vorwärtsweg (Downstream) oder im Rückwärtsweg (Upstream). Die Kontrolleinrichtung ist vorzugsweise über einen Steckplatzanschluss mit einer Platine des Breitbandverstärkers verbunden. So wird ein schneller Austausch der Kontrolleinrichtung ermöglicht.

Vorzugsweise arbeitet die Kontrolleinrichtung bidirektional, d.h., dass es auch möglich ist, mit der Kontrolleinrichtung oder einem Modem der Kontrolleinrichtung Signale über das Breitbandkabel zu übertragen, wobei die Übertragung in diesem Fall in die umgekehrte Richtung erfolgt, also von der Kontrolleinrichtung aus über den Eingang des Breitbandverstärkers in Richtung des CMTS (upstream), wo durch die Kontrolleinrichtung eingespeiste Signale wiederum entschlüsselt werden können. Dies bietet den Vorteil, dass auch Informationen über den Verstärker in Richtung des CMTS gesendet werden können. Besonders bevorzugt wird, falls die Kontrolleinrichtung geeignet ist, den Wert eines Parameters des Breitbandverstärkers über den Eingang auszusenden. Dies geschicht durch , dass die Kontrolleinrichtung mit einem Modem, insbesondere mit einem DOCSIS-Modem ausgerüstet ist.

Weiterhin ist die Kontrolleinrichtung vorzugsweise mittels eines Rückwegmoduls mit dem Eingang verbunden. Das Rückwegmodul umfasst vorteilhafterweise einen Richtkoppler. Der Richtkoppler bietet den Vorteil, dass ein sauberes Einspeisen der Rücksignale in den Rückwärtsweg (upstream), d.h. der Signale, welche von der Kontrolleinrichtung in Richtung des CMTS gesendet werden, möglich ist. Das Rückwegmodul weist hierzu vorzugsweise einen Pegelsteller auf, mit dem ein Pegel eines von dem Richtkoppler über den Eingang eingespeisten Rückwegsignals einstellbar ist. Dabei ist das Rückwegsignal das Rücksignal, welches von dem Modem in Richtung des CMTS gesendet wird. Der Pegelsteller des Rückwegmoduls ist vorzugsweise durch die Kontrolleinrichtung steuerbar. Dies bietet den Vorteil, dass ferngesteuert über die Kontrolleinrichtung das Rückwegmodul so eingestellt werden kann, dass das Rücksignal oder das Rückwegsignal ideal in Richtung des CMTS übertragen wird.

Vorteilhafterweise umfasst der Breitbandverstärker oder der Verstärker einen Entzerrer, welcher durch die Kontrolleinrichtung steuerbar ist. Der Entzerrer ist im Signalweg hinter dem Eingang (downstream) angeordnet und dient der Verbesserung der Verstärkung. Durch die Überwachung von Signalen, beispielsweise eines Ausgangssignals des Verstärkers, kann im Zusammenspiel mit der Steuerung der Pegelsteller oder der Steuerung des Entzerrers ein Regelkreis aufgebaut werden, welcher eine ideale Verstärkung ermöglicht und außerdem fernsteuerbar ist.

Vorteilhafterweise umfasst der Breitbandverstärker einen mit der Kontrolleinrichtung verbundenen semi-permanenten oder persistenten Speicher. Mit solchen Speichern sind Speicher gemeint, welche bei einem Ausfall einer Stromversorgung des Breitbandverstärkers oder auch bei einer längerfristigen Stromlosschaltung des Breitbandverstärkers die gespeicherten Daten behalten. Der Speicher wird vorzugsweise verwendet, um Einstellungen, beispielsweise Einstellungen des Verstärkers, des Entzerrers oder allgemein von Pegelstellern oder auch von Einstellungen von Schaltern zu speichern, sodass nach einer Wiederinbetriebnahme durch ein Aufschalten von Strom automatisch wieder die alten Einstellungen verwendet werden.

Vorteilhafterweise umfasst der Breitbandverstärker zumindest einen Ausgang, dem ein durch die Kontrolleinrichtung steuerbarer Schalter zugeordnet ist, um den Ausgang zu schalten. Dabei ist mit Schalten unter anderem gemeint, dass der Ausgang ein- oder ausgeschaltet werden kann, oder auch dass der Ausgang einem Signalweg, auch einem von mehreren Signalwegen, aufgeschaltet werden kann. So umfasst der Breitbandverstärker vorzugsweise mindestens eine Weiche, die zumindest zwei verschiedene Frequenzbänder auf zwei Signalwegen bereitstellt, wobei mit dem Ausdruck "verschiedene Frequenzbänder" auch umfasst sein soll, dass auf dem einen Signalweg das volle Frequenzband des Breitbandverstärkers und auf dem anderen Signalweg lediglich ein Ausschnitt des vollen Frequenzbandes zur Verfügung steht. Durch Fernsteuern des Schalters, welcher einem jeweiligen Ausgang zugeordnet ist, wird es ermöglicht, diesen Ausgang auf einen bestimmten von verschiedenen Signalwegen zu schalten. Dies bietet den Vorteil, dass fernsteuerbar verschiedenen Teilnehmern, die an verschiedenen Ausgängen des Breitbandverstärkers angeschlossen sind, fernsteuerbar verschiedene Frequenzbänder freigeschaltet werden können. Auf diese Weise ist es möglich, einen Ausgang beispielsweise nur dann voll freizuschalten, falls der jeweilige Teilnehmer eine entsprechende Gebühr bezahlt oder falls der jeweilige Teilnehmer nicht nur ein Fernsehsignal (broadcast) empfangen darf sondern auch einen Netzwerkanschluss bekommt. Hierzu umfasst der Breitbandverstärker vorzugsweise mehrere Ausgänge, die schaltbar sind. Vorteilhafterweise ist der Schalter so angeordnet, dass er einen jeweiligen Ausgang wahlweise mit einem ersten Signalweg oder einem zweiten Signalweg verbinden kann. Die Signalwege sind, wie oben beschrieben, vorzugsweise mit dem Verstärker verbunden, wobei Frequenzfilter zwischengeschaltet sein können, um bestimmte Frequenzbereiche zu erzeugen. Von der Erfindung ausdrücklich umfasst ist auch die Lösung, dass mehr als lediglich zwei Signalwege vorhanden sind.

Die Kontrolleinrichtung umfasst weiterhin vorzugsweise eine serielle oder parallele Schnittstelle (Ethernet) für ein lokales Netzwerk (LAN), sodass die Kontrolleinrichtung auch unmittelbar mit einem Laptop vor Ort verbunden werden kann. Dabei kann diese Schnittstelle auch bei dem Modem realisiert sein. Eine solche Schnittstelle bietet den Vorteil, dass bei Problemen mit der Fernsteuerbarkeit der Kontrolleinrichtung vor Ort Problemlösungen gefunden werden können. Die Schnittstelle umfasst vorzugsweise einen DHCP-Server, so dass ein Anschliessen eines Laptops erleichtert wird. Das Modem ist vorzugsweise eingerichtet, so dass es von einem CMTS eine Internetadresse beziehen kann, beispielsweise über eine DHCP-Routine. Vorteilhafterweise haben das Modem oder die Schnittstelle jeweils eigene MAC-Adressen, über die sie eindeutig identifizierbar sind. Die Kontrolleinheit bietet bei typischen Ausführungsformen eine Option 60 (DHCP) - Abfrage - Funktionalität (bspw. "Amplifier V1.0" oder "Verstärker V 1.0"), mit welcher die Kontrolleinheit als in einem Breitbandverstärker eingebaute Kontrolleinheit identifizierbar ist.

Vorzugsweise können durch einen bevorzugten Breitbandverstärker mit einer Kontrolleinrichtung folgende Größen überwacht oder abgefragt werden, wobei die Überwachung vorzugsweise "remote" erfolgt, d.h. vorzugsweise entfernt über das Breitbandkabelnetz: Pegel des Radiofrequenz-Breitband-Signals, die Güte des Signals, beispielsweise das Rauschverhältnis oder auch die Bit-Fehlerrate (BER: Bit Error Ratio), der Zustand einer Stromversorgung, eine Temperatur, der Zustand eines Alarms, die Identifikation des Breitbandverstärkers, wie beispielsweise der Typ, die Seriennummer, der Aufstellungsort, der Status des Breitbandverstärkers, die "Weblog History" (Darstellung vergangener Netz-Ereignisse), ein Zustand eines SCS (Subscriber Control Switch, Teilnehmeranschluss-Kontrollschalter), ICS (Ingress Control Switch, Zustand eines Rückweg-Zutrittskontrollschalters), ein ACC (Automatic Channel Scan, automatischer Kanalsuchlauf), Zustand eines ALC (Automatic Level Control, automatische Pegelüberwachung).

Ein erfindungsgemäßer Breitbandverstärker bietet den Vorteil, dass von einem entfernten Platz aus ein Überwachen von Funktionalitäten und Funktionen des Breitbandverstärkers möglich ist, so dass ein Arbeiten an dem Breitbandverstärker vor Ort auf ein Minimum reduziert wird, wodurch Kosten reduziert werden.

### Figurenbeschreibung

Die Erfindung wird nachfolgend anhand einiger schematischer Zeichnungen beschrieben, wobei die Zeichnungen zeigen:
Fig. 1 zeigt schematisch einen erfindungsgemäßen Breitbandverstärker mit einer Kontrolleinrichtung;
Fig. 2 zeigt schematisch den Aufbau zur Fernsteuerung des Breitbandverstärkers der Fig. 1; und
Fig. 3 zeigt einen weiteren erfindungsgemäßen Breitbandverstärker.

### Beschreibung von Ausführungsbeispielen

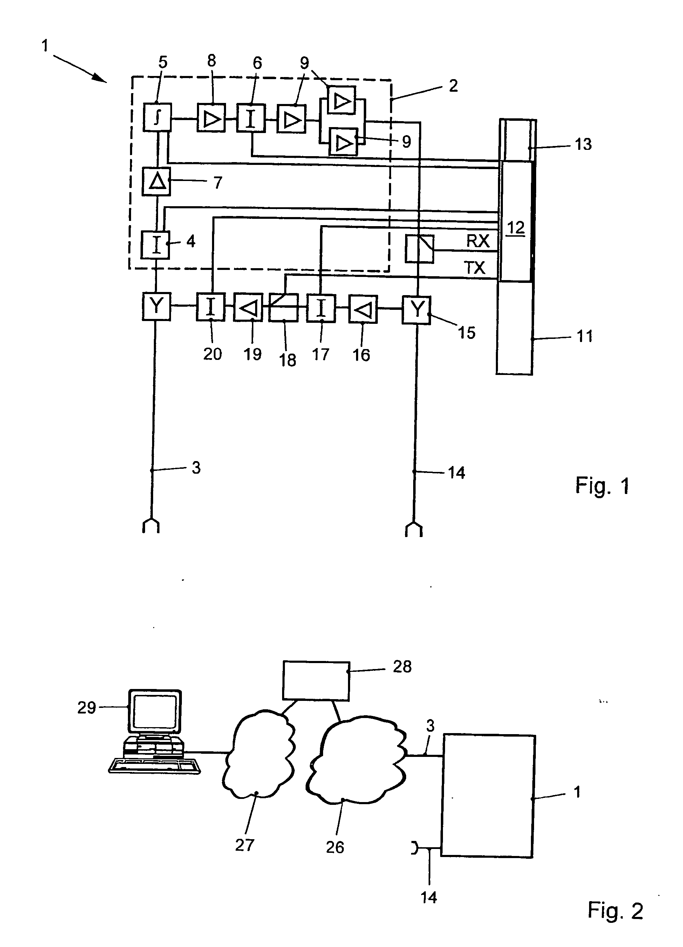

In der Fig. 1 ist ein Breitbandverstärker 1 gezeigt, der einen Verstärker 2 umfasst. Der Verstärker 2 dient dazu, ein über einen Eingang 3 empfangenes Breitbandsignal zu verstärken. Um den Verstärker 2 einstellen zu können, verfügt der Verstärker 2 über einen ersten Verstärkerpegelsteller 4, einen einstellbaren Entzerrer 5 und einen Interstage-Pegelsteller 6. Der Verstärkerpegelsteller 4 ist eingangsseitig mit dem Eingang 3 verbunden und ausgangsseitig mit einer Verstärkungsstufe 7. Am Ausgang der Verstärkungsstufe 7 ist der Entzerrer 5 angeordnet, dessen Signal in eine weitere Verstärkungsstufe 8 eingespeist wird. Das verstärkte Signal gelangt zu dem Interstage-Pegelsteller 6, dessen Ausgang wiederum mit Verstärkerstufen 9 verbunden ist. Vom Ausgang der Verstärkerstufen 9 gelangt das nunmehr aufbereitete Eingangssignal zu einer Empfangssignalabzweigung 10, an der ein Empfangssignal "RX" für eine Kontrolleinrichtung 11 abgezweigt wird. Die Kontrolleinrichtung 11 umfasst ein Modem 12, um DOCSIS-Signale zu decodieren. Außerdem verfügt die Kontrolleinrichtung 11 über eine Schnittstelle 13 für einen Ethernet-Netzwerkanschluss, über welchen die Kontrolleinrichtung 11 direkt mit einem Laptop oder einem anderen Computer verbindbar ist.

Die Kontrolleinrichtung umfasst vorzugsweise einen Server, der über das Modem im Internet abrufbare Daten zur Verfügung stellt. Der Server stellt vorteilhafterweise Web-Seiten bereit, über die Informationen über den Breitbandverstärker abgerufen werden können oder über die eine Konfiguration der Kontrolleinrichtung oder des Breitbandverstärkers möglich ist. Der Server bietet typischerweise verschiedene Benutzer-Berechtigungs-Ebenen für Benutzer. Dies bietet den Vorteil, dass verschiedene Benutzer angelegt werden können, wobei die verschiedenen Nutzer unterschiedliche Befugnisse für einen Datenabruf oder eine Konfiguration der Kontrolleinrichtung haben. Benutzer können dabei über die Schnittstelle oder über das Internet und das Modem auf die Kontrolleinrichtung zugreifen. Typische Ausführungsformen ermöglichen eine Familienkonfiguration, wobei die Kontrolleinrichtung einstellbar ist, so dass sie einer bestimmten Familie von Breitbandverstärkern zugeordnet ist. Eine Familienkonfiguration bewirkt eine gleichzeitige Konfiguration alle einer bestimmten Familie zugeordneten Breitbandverstärker. Die Kontrolleinrichtung ist vorzugsweise auch dazu eingerichtet, Software-Aktualisierungen zu empfangen, insbesondere selbständig oder automatisch Software-Aktualisierungen durchzuführen. Der Server ist vorzugsweise eingerichtet, so dass über den Server eine IP-Verbindung der Kontrolleinrichtung steuerbar ist. Typische Ausführungsformen lassen einen Zugriff auf den Server und ein Steuern einer IP-Verbindung über die LAN-Schnittstelle der Kontrolleinrichtung zu.

Außerdem wird das aufbereitete Signal an einem Ausgang 14 bereitgestellt. Vor dem Ausgang 14 ist in dem Signalweg noch eine Rückweg-Signalweiche 15 angeordnet, über die ein Rückweg aufgebaut wird. In dem Rückweg ist zunächst wiederum eine Verstärkerstufe 16 und ein ICS-Kontrollschalter (ICS: Ingress Control Switch) 17 angeordnet. Der ICS-Kontrollschalter dient dazu, den Rückweg zu dämpfen oder ganz zu sperren, falls über den Ausgang 14 Störsignale eingespeist werden. So kann mit der Kontrolleinrichtung fernsteuerbar schnell auf das Auftreten von Störsignalen reagiert werden. Darauffolgend ist ein Richtkoppler 18 zum Einspeisen eines Sendesignals "TX" der Kontrolleinrichtung 11 angeordnet. Das Rückwegsignal mit dem eingespeisten Sendesignal "TX" gelangt zu einer weiteren Verstärkungsstufe 19, deren Ausgangssignal wiederum über einen Rückweg-Pegelsteller 20 einstellbar ist. Die Verstärkerstufe 16, der ICS-Kointrollschalter 17, der Richtkoppler 18, die Verstärkungsstufe 19 und der Pegelsteller 20 sind Teile eines Rückwegmoduls. Über einen weiteren Knotenpunkt 21 gelangt das Sendesignal "TX" zusammen mit den übrigen Signalen des Rückwegs wiederum zum Eingang 3, von wo es weiter zu einem CMTS, der Teil einer Kopfstelle ist,übermittelt wird.

Die dargestellte bevorzugte Ausführungsform bietet den Vorteil, dass über die Kontrolleinrichtung 11 verschiedene Einstellungen an dem Breitbandverstärker 1 vorgenommen werden können. So ist die Kontrolleinrichtung 11 dazu eingerichtet, unter anderem den Verstärker-Pegelsteller 4, den Entzerrer 5 und den Interstage-Pegelsteller 6 einzustellen, um auf die Qualität und den Pegel des Eingangssignals Einfluss zu nehmen. Daneben verarbeitet die Kontrolleinrichtung aber auch die Signalstärken und die Qualität des Signals, beispielsweise des Signals, das an dem Verstärker-Pegelsteller 4 eingangsseitig anliegt. Auf diese Weise ist mit der Kontrolleinrichtung 11 auch eine Überwachung der Signale möglich, da die Kontrolleinrichtung 11 über das Sendesignal "TX" auch Informationen über die Signale, wie bspw. Signalqualität, wieder an einen entfernten Rechner oder das CMTS senden kann. Außerdem kann über die Kontrolleinrichtung auch Einfluss genommen werden auf den Rückweg, insbesondere auf die Stärke des Rückwegsignals oder den ICS-Schalter 17. Im Einzelnen kann insbesondere der Rückweg-Pegelsteller 20 angesteuert werden, um die Stärke des Rückweg-Signals einzustellen. Vor einem Steuern bzw. Einstellen einer Größe oder eines Pegels mittels des Pegelstellers 20 durch die Kontrolleinrichtung 11 wird eine Plausibilitätskontrolle durchgeführt, wobei das Steuern der Größe oder des Pegels bei einem negativen Ausgang der Plausibilitätskontrolle unterbleibt. Die Plausibilitätskontrolle überprüft dabei, ob es bei der geforderten Soll-Einstellung des Pegelstellers 20 dazu kommen könnte, dass die Kontrolleinrichtung 11 nicht mehr erreichbar wäre oder Signale des Modems 12 nicht mehr übermittelt würden. Dies bietet den Vorteil, dass es nicht zu einem "Abschalten" der Internetverbindung des Breitbandverstärkers 1 kommen kann.

In der Fig. 2 ist in der Übersicht das Zusammenwirken eines Breitbandverstärkers 1 mit einem CMTS 28 einer Kopfstelle gezeigt. Zwischen dem Breitbandverstärker 1, genauer gesagt dessen Ausgang 3, und dem CMTS 28 befindet sich ein Verteilernetz 26. Von dem Verteilernetz 26 aus werden verschiedene Breitbandverstärker 1 mit Signalen versorgt, wobei in der Fig. 2 lediglich ein Breitbandverstärker 1 dargestellt ist. An der Kopfstelle des CMTS 28 wird auch ein Fernsehsignal eingespeist, das mit dem Verteilernetz 26 verteilt wird. Außerdem ist das CMTS 28 an das Internet 27 angeschlossen, so dass eine Verbindung zu einem Computer 29 hergestellt wird. Über den Computer 29 können Einstellungen der Kontrolleinrichtung 11 des Breitbandverstärkers 1 vorgenommen werden. Dabei wird über das CMTS 28 und das Modem 12 eine Verbindung zwischen dem Computer 29 und der Kontrolleinrichtung 11 hergestellt. Vorzugsweise erfolgt die Bedienung der Kontrolleinrichtung 11 über durch die Kontrolleinrichtung 11 bereitgestellte HTML-Seiten mit dem Computer 29. Die Kontrolleinrichtung 11 weist vorzugsweise eine Server-Funktionalität auf. Die Kontrolleinrichtung 11 stellt über diesen Webserver zweckmäßigerweise Daten des Breitbandverstärkers bereit und ermöglicht eine Konfiguration des Breitbandverstärkers. Dies bietet den Vorteil, dass auf die Kontrolleinrichtung einfach über das Internet zugegriffen werden kann.

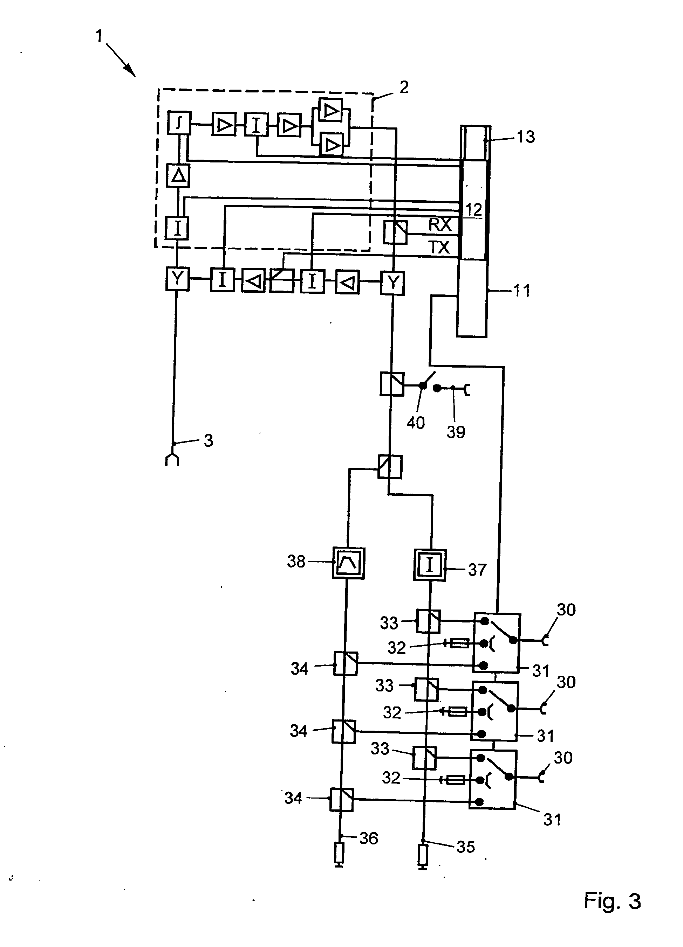

Anzumerken ist, dass in den Figuren 1 bis 3 gleiche oder ähnliche Teile mit gleichen Bezugszeichen bezeichnet werden. Außerdem entspricht der Breitbandverstärker 1 der Fig. 2 dem in der Fig.1 1 dargestellten Breitbandverstärker 1. In der Fig. 3 sind nicht alle Teile des dort dargestellten Breitbandverstärkers 1 mit Bezugszeichen versehen, hierzu wird auf die Fig. 1 und die dazugehörige Erläuterung verwiesen.

In der Fig. 3 ist eine weitere bevorzugte Ausführungsform eines Breitbandverstärkers 1 dargestellt, wobei der Breitbandverstärker 1 der Fig. 3 über grundsätzlich die gleiche Aufbereitung des Eingangssignals und auch über die gleiche Einspeisemöglichkeit für ein Rücksendesignal "TX" von der Kontrolleinrichtung 11 verfügt.

Im Gegensatz zu dem Breitbandverstärker der Fig. 1 verfügt der Breitbandverstärker 1 der Fig. 3 jedoch über mehrere schaltbare Ausgänge 30. Jedem dieser schaltbaren Ausgänge 30 ist ein Schalter 31 zugeordnet, über welchen eingestellt werden kann, ob der jeweilige Ausgang 30 auf Masse 32, einen ersten Signalwegabgriff 33 oder einen zweiten Signalwegäbgriff 34 geschaltet wird. Die verschiedenen Signalwegabgriffe 33 der mehreren Ausgänge 30 greifen auf einen ersten Signalweg 35 zu, wobei die Signalwegabgriffe 34 auf einen zweiten Signalweg 36 zugreifen. Der erste Signalweg 35 wird über einen Signalwegpegelsteller 37 mit einem Signal versorgt, das dem gesamten Frequenzband des am Eingang 3 anliegenden Breitbandsignals entspricht. Dazu ist der Signalwegpegelsteller 37 mit der Signalaufbereitung des Verstärkers 2 verbunden. Außerdem wird mit dem Ausgangssignal des Verstärkers 2 auch ein Bandpass-Filter 38 gespeist, dessen Ausgangssignal an dem zweiten Signalweg 36 zur Verfügung steht. Auf diese Weise steht auf dem Signalweg 36 nur ein Teilbereich des gesamten Breitband-Spektrums zur Verfügung, sodass mit den Schaltern 31 Ausgänge 30 für ausgesuchte Teilnehmer so eingestellt werden können, dass diese Teilnehmer lediglich ein eingeschränktes Spektrum und damit eine eingeschränkte Anzahl von Fernsehprogrammen des Breitband-Signals empfangen können. Eine andere Einsatzmöglichkeit für die mehreren Signalwege ist ein selektives Freigeben eines Internetzugangs, der auf einem bestimmten Frequenzbereich abgewickelt wird, für bestimmte Teilnehmer an bestimmten der Ausgänge 30.

Weiterhin verfügt der Breitbandverstärker 1 der Fig.3 auch über einen zuschaltbaren Systemausgang 39, über welchen das aufbereitete Signal des Verstärkers 2 direkt abgegriffen werden kann. Der zuschaltbare Systemausgang 39 ist über einen Schalter 40 schaltbar, wobei der Schalter 40 durch die Kontrolleinrichtung 11 ansteuerbar ist. Außerdem steuert die Kontrolleinrichtung 11 die Zustände der Schalter 30 und kann somit bestimmen, an welchem Ausgang und damit für welchen Teilnehmer welches Breitband-Fernsehsignal zur Verfügung steht. Auf diese Weise ist es möglich, über die Kontrolleinrichtung 11 von einem entfernten Punkt aus, beispielsweise von dem Computer 29 (Fig. 2) aus zu steuern, welcher Teilnehmer welches Signal empfangen kann oder welcher Teilnehmer Internetzugang erhält.

**Bezugszeichenliste**

| | | | | | |
|---|---|---|---|---|---|
| 1 | Breitbandverstärker | 34 | zweiter Signalwegabgriff | 67 | |
| 2 | Verstärker | 35 | erster Signalweg | 68 | |
| 3 | Eingang | 36 | zweiter Signalweg | 69 | |
| 4 | Verstärker-Pegelsteller | 37 | Signalwegpegelsteller | 70 | |
| 5 | Entzerrer | 38 | Bandpass-Filter | 71 | |
| 6 | Interstage-Pegelsteller | 39 | Systemausgang | 72 | |
| 7 | Verstärkerstufe | 40 | Schalter | 73 | |
| 8 | Verstärkerstufe | 41 | | 74 | |
| 9 | Verstärkerstufen | 42 | | 75 | |
| 10 | Empfangssignalabzweigung | 43 | | 76 | |
| 11 | Kontrolleinrichtung | 44 | | 77 | |
| 12 | Modem | 45 | | 78 | |
| 13 | Schnittstelle | 46 | | 79 | |
| 14 | Ausgang | 47 | | | |
| 15 | Knotenpunkt | 48 | | | |
| 16 | Verstärkerstufe | 49 | | | |
| 17 | ICS-Schalter | 50 | | | |
| 18 | Richtkoppler | 51 | | | |
| 19 | Verstärkungsstufe | 52 | | | |
| 20 | Rückweg-Pegelsteller | 53 | | | |
| 21 | Knotenpunkt | 54 | | | |
| 22 | | 55 | | | |
| 23 | | 56 | | | |
| 24 | | 57 | | | |
| 28 | | 58 | | | |
| 26 | Verteilernetz | 59 | | | |
| 27 | Internet | 60 | | | |
| 28 | CMTS | 61 | | | |
| 29 | Computer | 62 | | | |
| 30 | Ausgänge f.Teilnehmer | 63 | | | |
| 31 | Schalter | 64 | | | |
| 32 | Masse | 65 | | | |
| 33 | erster Signalwegabgriff | 66 | | | |

## Patentansprüche

1. Breitbandverstärker (1) zur Verwendung in einem Breitbandkabelnetz, insbesondere in einem Breitbandkabelnetz zur Übertragung von Fernsehsignalen, mit einem Eingang (3) und einem mit dem Eingang (3) verbundenen Verstärker (2), mit einer mit dem Eingang (3) verbundenen Kontrolleinrichtung (11), die geeignet ist, in Abhängigkeit von einem über den Eingang (3) oder einen Ausgang (30) empfangenen Signal den Verstärker (2) zu steuern, wobei die Kontrolleinrichtung (11) ein DOCSIS-Modem (12) umfasst,
**dadurch gekennzeichnet,**
**dass** vor einem Steuern einer Größe oder eines Pegels mittels eines Pegelstellers (20) die Kontrolleinrichtung (11) geeignet ist, eine Plausibilitätskontrolle durchzuführen und das Steuern der Größe oder des Pegels bei einem negativen Ausgang der Plausibilitätskontrolle unterbleibt, wobei die Plausibilitätskontrolle dabei überprüft, ob es bei der geforderten Soll-Einstellung des Pegelstellers (20) dazu kommen könnte, dass die Kontrolleinrichtung (11) nicht mehr erreichbar wäre oder Signal & des Modems (12) nicht mehr übermittelt würden.

2. Breitbandverstärker (1) nach Anspruch 1, **gekennzeichnet durch** mindestens den Ausgang (30), dem ein **durch** die Kontrolleinrichtung (11) steuerbarer Schalter (31) zugeordnet ist, um den Ausgang (30) zu schalten.

3. Breitbandverstärker (1) nach einem der vorhergehenden Ansprüche, **dadurch gekennzeichnet, dass** der Schalter (31) angeordnet ist, so dass mit dem Schalter (31) der Ausgang (30) wahlweise mit einem ersten Signalweg (35) oder einem zweiten Signalweg (36) verbindbar ist.

4. Breitbandverstärker (1) nach einem der vorhergehenden Ansprüche, **dadurch gekennzeichnet, dass** die Kontrolleinrichtung (11) geeignet ist, den Wert eines Parameters des Breitbandverstärkers (1) über den Eingang (3) auszusenden.

5. Breitbandverstärker (1) nach Anspruch 4, **dadurch gekennzeichnet, dass** die Kontrolleinrichtung (11) mittels eines Rückwegmoduls mit dem Eingang (3) verbunden ist.

6. Breitbandverstärker (1) nach Anspruch 5, **dadurch gekennzeichnet, dass** das Rückwegmodul einen Pegelsteller (20) aufweist, mit dem ein Pegel eines Rückwegsignals einstellbar ist.

7. Breitbandverstärker (1) nach einem der vorhergehenden Ansprüche, **gekennzeichnet durch** eine mit der Kontrolleinrichtung (11) verbundene Überwachungseinrichtung (10), welche geeignet ist, einen Signalpegel zu ermitteln und an die die Kontrolleinrichtung (11) zu übermitteln.

8. Breitbandverstärker (1) nach einem der vorhergehenden Ansprüche, **gekennzeichnet durch** einen Entzerrer (5), der **durch** die Kontrolleinrichtung (11) steuerbar ist.

9. Breitbandverstärker (1) nach einem der vorhergehenden Ansprüche, **dadurch gekennzeichnet, dass** die Kontrolleinrichtung (11) einen Server umfasst.

10. Breitbandverstärker (1) nach Anspruch 9, **dadurch gekennzeichnet, dass** der Server eingerichtet ist, so dass über den Server eine IP-Verbindung der Kontrolleinrichtung steuerbar ist.

11. Breitbandverstärker (1) nach einem der vorhergehenden Ansprüche, **dadurch gekennzeichnet, dass** die Kontrolleinrichtung (11) eine LAN-Schnittstelle umfasst.

## Claims

1. Broadband amplifier (1) for use in a broadband cable network, in particular in a broadband cable network for the transmission of television signals, having an input (3) and an amplifier (2) connected to the input (3), having a control device (11) connected to the input (3), which device is suitable for controlling the amplifier (2) in dependence on a signal received via the input (3) or an output (30), the control device (11) comprising a DOCSIS modem (12),
**characterised**
**in that**, before a control of a quantity or a level by means of a level controller (20), the control device (11) is suitable for carrying out a plausibility check and the control of the quantity or level does not take place in the event of a negative output of the plausibility check, the plausibility check here checking whether in the case of the required adjustment of the level controller (20) it could happen that the control device (11) would no longer be reachable or signals of the modem (12) would no longer be transmitted.

2. Broadband amplifier (1) according to Claim 1, **characterised by** at least the output (30), to which is assigned a switch (31) controllable by the control device (11), in order to switch the output (30).

3. Broadband amplifier (1) according to one of the preceding claims, **characterised in that** the switch (31) is arranged such that the output (30) is selectively connectable to a first signal path (35) or a second signal path (36) by the switch (31).

4. Broadband amplifier (1) according to one of the preceding claims, **characterised in that** the control device (11) is suitable for sending out the value of a parameter of the broadband amplifier (1) via the input (3).

5. Broadband amplifier (1) according to Claim 4, **characterised in that** the control device (11) is connected to the input (3) by means of a return path module.

6. Broadband amplifier (1) according to Claim 5, **characterised in that** the return path module has a level controller (20), by which a level of a return path signal is adjustable.

7. Broadband amplifier (1) according to one of the preceding claims, **characterised by** a monitoring device (10) which is connected to the control device (11) and is suitable for determining a signal level and transmitting it to the control device (11).

8. Broadband amplifier (1) according to one of the preceding claims, **characterised by** an equaliser (5) which is controllable by the control device (11).

9. Broadband amplifier (1) according to one of the preceding claims, **characterised in that** the control device (11) comprises a server.

10. Broadband amplifier (1) according to Claim 9, **characterised in that** the server is set up such that an IP connection of the control device (11) is controllable via the server.

11. Broadband amplifier (1) according to one of the preceding claims, **characterised in that** the control device (11) comprises a LAN interface.

## Revendications

1. Amplificateur de bande large (1) destiné à être utilisé dans un réseau de câble de bande large, en particulier dans un réseau de câble de bande large pour la transmission de signaux de télévision, avec une entrée (3) et un amplificateur (2) connecté à l'entrée (3), avec un dispositif de contrôle (11) connecté à l'entrée (3), qui convient pour régler l'amplificateur (2) en fonction d'un signal reçu via l'entrée (3) ou une sortie (30), le dispositif de contrôle (11) comprenant un modem DOCSIS (12),
**caractérisé par le fait**
**qu'**avant un réglage d'une grandeur ou d'un niveau au moyen d'un régleur de niveau (20), le dispositif de contrôle (11) convient pour effectuer un contrôle de plausibilité et que le réglage de la grandeur ou du niveau est omis en cas de sortie négative du contrôle de plausibilité, le contrôle de plausibilité vérifiant s'il pourrait se produire, en cas de réglage de consigne requis du régleur de niveau (20), que le dispositif de contrôle (11) ne puisse plus être atteint ou que les signaux du modem (12) ne soient plus transmis.

2. Amplificateur de bande large (1) selon la revendication 1, **caractérisé par** au moins la sortie (30) à laquelle est associé un commutateur (31) pouvant être commandé par le dispositif de contrôle (11), pour commuter la sortie (30).

3. Amplificateur de bande large (1) selon l'une des revendications précédentes, **caractérisé par le fait que** le commutateur (31) est disposé de sorte que par le commutateur (31) la sortie (30) puisse être reliée alternativement à un premier trajet de signal (35) ou un deuxième trajet de signal (36).

4. Amplificateur de bande large (1) selon l'une des revendications précédentes, **caractérisé par le fait que** le dispositif de contrôle (11) convient pour envoyer la valeur d'un paramètre de l'amplificateur de bande large (1) via l'entrée (3).

5. Amplificateur de bande large (1) selon la revendication 4, **caractérisé par le fait que** le dispositif de contrôle (11) est relié à l'aide d'un module de retour à l'entrée (3).

6. Amplificateur de bande large (1) selon la revendication 5, **caractérisé par le fait que** le module de retour présente un régleur de niveau (20) par lequel peut être réglé un niveau d'un signal de retour.

7. Amplificateur de bande large (1) selon l'une des revendications précédentes, **caractérisé par** un dispositif de surveillance (10) connecté au dispositif de contrôle (11), lequel convient pour déterminer un niveau de signal et le transmettre au dispositif de contrôle (11).

8. Amplificateur de bande large (1) selon l'une des revendications précédentes, **caractérisé par** un égalisateur (5) qui peut être commandé par le dispositif de contrôle (11).

9. Amplificateur de bande large (1) selon l'une des revendications précédentes, **caractérisé par le fait que** le dispositif de contrôle (11) comporte un serveur.

10. Amplificateur de bande large (1) selon la revendication 9, **caractérisé par le fait que** le serveur est aménagé de sorte que par l'intermédiaire du serveur puisse être réglée une connexion IP du dispositif de contrôle.

11. Amplificateur de bande large (1) selon l'une des revendications précédentes, **caractérisé par le fait que** le dispositif de contrôle (11) comporte une interface LAN.
